# EUROPEAN PATENT APPLICATION

(11) **EP 4 194 194 A1**
(43) Date of publication of application: **14.06.2023**
(21) Application number: 21853447.7
(22) Date of filing: 28.07.2021
(51) Int. Cl.: B32B 5/14, B32B 5/24, H01Q 17/00, H05K 9/00

(54) **MULTILAYER BODY AND ELECTROMAGNETIC WAVE ABSORBER**

(30) Priority: 05.08.2020 JP 2020132858
(71) Applicant: Nitto Denko Corporation, Ibaraki-shi, Osaka 567-8680 (JP); OSAKA UNIVERSITY, Suita-shi Osaka 565-0871 (JP)
(72) Inventor: KAMANO, Yusuke, Ibaraki-shi, Osaka 567-8680 (JP); MASUDA, Shotaro, Ibaraki-shi, Osaka 567-8680 (JP); NAGAI, Masaya, Suita-shi, Osaka 565-0871 (JP); NAGATSUMA, Tadao, Suita-shi, Osaka 565-0871 (JP); FUJITA, Masayuki, Suita-shi, Osaka 565-0871 (JP)
(74) Representative: Hoffmann Eitle
(86) International application number: PCT/JP2021/027978
(87) International publication number: WO 2022/030335

(57) **Abstract**

According to the present invention, a laminate has: a fiber aggregate including a plurality of nanofibers aggregated into a sheet; and a reflective substrate on which the fiber aggregate is placed and which has a reflectance of 0.1% or more. In this laminate, the fiber aggregate includes: a first orientation part formed in a part of a thickness direction of the fiber aggregate; and a second orientation part formed nearer to the reflective substrate than the first orientation part and having a lower degree of orientation than the first orientation part.

## Description

### Technical Field

The present invention relates to a laminate and an electromagnetic wave absorber.

### Background Art

In various information communication systems such as represented by mobile phones, wireless LANs, automatic toll collection (ETC) systems, intelligent transportation systems, automobile driving support road systems, and satellite broadcasting, electromagnetic waves called centimeter waves with frequency bands of several gigahertz (GHz) are mainly used.

In recent years, in order to further increase the capacity of data to be transmitted, research is in progress on technologies that use electromagnetic waves of higher frequency bands such as millimeter waves with frequencies in what is known as the millimeter wave band of 30 GHz - 300 GHz, terahertz (THz) waves with frequencies in what is known as the terahertz band of 300 GHz - 3 terahertz, and so forth.

The future has to cope with such technologies that use electromagnetic waves in higher frequency bands, and it might follow that, for electromagnetic wave absorbers that absorb electromagnetic waves, the demand for electromagnetic wave absorbers that can demonstrate electromagnetic wave absorption performance for electromagnetic waves in the millimeter wave band and above will increase.

As such an electromagnetic wave absorber for absorbing higher frequency electromagnetic waves, for example, a carbon nanotube aggregate, in which a plurality of carbon nanotubes are aligned vertically on a silicon substrate, and which can demonstrate high absorption performance from the THz domain to the infrared domain is disclosed (see, for example, Non-Patent Document 1).

### Citation List

### Patent Document

[Non-Patent Document 1] Leimeng Sun et al., "Wafer-scale vertically aligned carbon nanotubes for broadband terahertz wave absorption," Carbon, vol. 154, p. 503-509 (2019)

### Summary of the Invention

### Problem to be Solved by the Invention

However, Non-Patent Document 1 does not describe the impact, on the absorption performance of electromagnetic waves of the millimeter wave band or above, when the orientation (angle) of carbon nanotubes formed on a silicon substrate changes in the lengthwise direction. When using an aggregate of carbon nanotubes as an electromagnetic wave absorber as in Non-Patent Document 1, variation could be made in the orientation of the carbon nanotubes in the lengthwise direction so as to improve the absorption performance of electromagnetic waves in the millimeter wave band or above, but Non-Patent Document 1 is silent on this.

An object of one embodiment of the present invention is therefore to provide a laminate that, when used in an electromagnetic wave absorber, can absorb well high-frequency electromagnetic waves in the millimeter wave band or above.

### Means for Solving the Problem

According to one aspect of the present invention, a laminate has: a fiber aggregate including a plurality of nanofibers aggregated into a sheet; and a reflective substrate on which the fiber aggregate is placed and which has a reflectance of 0.1% or more. In this laminate, the fiber aggregate includes: a first orientation part formed in a part of a thickness direction of the fiber aggregate; and a second orientation part formed nearer to the reflective substrate than the first orientation part and having a lower degree of orientation than the first orientation part.

### Advantageous Effects of the Invention

The laminate according to one aspect of the present invention, when used as an electromagnetic wave absorber, can absorb well high-frequency electromagnetic waves of the millimeter wave band or above.

### Brief Description of the Drawings

[FIG. 1] FIG. 1 is a diagram that schematically shows a laminate according to a first embodiment of the present invention;
[FIG. 2] FIG. 2 is a diagram that explains the degree of orientation;
[FIG. 3] FIG. 3 is a schematic diagram of an apparatus for making carbon nanotube aggregates;
[FIG. 4] FIG. 4 is a diagram that schematically shows a laminate according to a second embodiment of the present invention;
[FIG. 5] FIG. 5 is a diagram that schematically shows a laminate according to a third embodiment of the present invention;
[FIG. 6] FIG. 6 is a perspective view of a laminate;
[FIG. 7] FIG. 7 is an SEM picture that shows a cross-section of a first orientation part in the thickness direction of a fiber aggregate according to an example 1;
[FIG. 8] FIG. 8 is an SEM picture that shows a cross-section of a second orientation part in the thickness direction of the fiber aggregate according to example 1; and
[FIG. 9] FIG. 9 is an diagram that explains the tensile test.

### Embodiments for Carrying Out the Invention

Hereinafter, embodiments of the present invention will be described in detail. Note that, in order to help understand the following description, the same components in each drawing will be assigned the same reference numerals, and redundant description will be omitted. Also, the scale of each component/member in the drawings may differ from the actual scale. In this specification, whenever a hyphen is used to indicate a numerical range, the numerical values before and after the hyphen are included as the lower and upper limits of that numerical range, unless otherwise specified.

### [First embodiment]

### <Laminate>

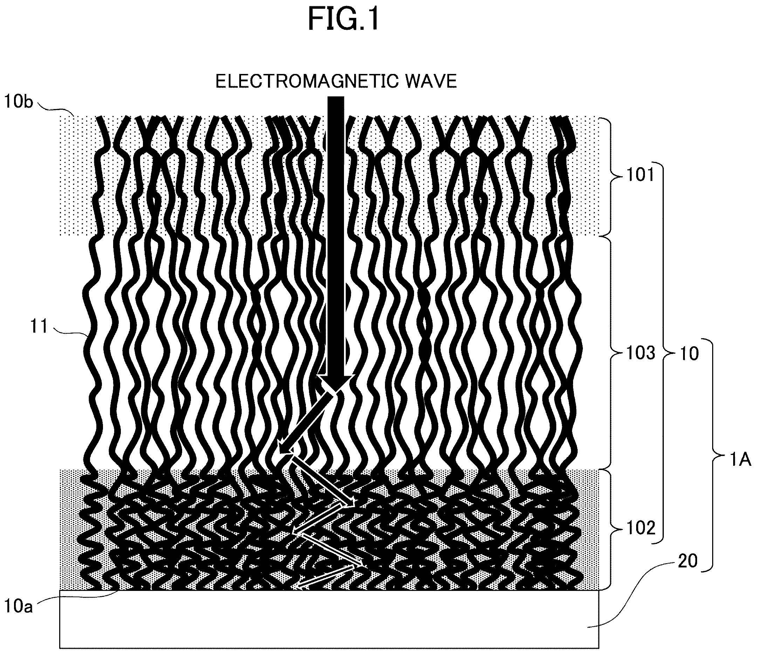

A laminate according to a first embodiment of the present invention will be described below. FIG. 1 is a diagram that schematically shows the laminate according to this embodiment. As shown in FIG. 1, a laminate 1A according to the present embodiment includes a fiber aggregate (sheet) 10, and a reflective substrate 20 on which the fiber aggregate 10 is placed. The laminate 1A can absorb electromagnetic waves that are incident downward from above, and attenuate the electromagnetic waves that get reflected. Note that the arrows shown in FIG. 1 indicate examples of directions in which electromagnetic waves travel, and the thickness of the arrows indicate the intensity of the electromagnetic waves.

Although, in this embodiment, the reflective substrate 20-side of the fiber aggregate 10 will be referred to as "the bottom" or "the lower side" and the side that is opposite the reflective substrate 20-side will be referred to as "the top" or "the upper side," this does not represent an absolute top-bottom relationship.

### (Fiber aggregate)

The fiber aggregate 10 includes a plurality of nanofibers 11, and these nanofibers 11 are aggregated to form a sheet. Then, the length of each nanofiber 11 extends from one main surface (lower surface) 10a of the sheet-like fiber aggregate 10 toward the other main surface (upper surface) 10b. On the whole, each nanofiber 11 extends substantially perpendicularly to the lower surface 10a and the upper surface 10b of the fiber aggregate 10. Each nanofiber 11 has its one end reach one lower surface 10 of the fiber aggregate 10 and the other end reach the other upper surface 10b of the fiber aggregate 10. In the fiber aggregate 10, the lower surface 10a may be the surface to contact the reflective substrate 20, and the upper surface 10b may be the surface to be located outside.

The nanofibers 11 preferably have an anisotropic dielectric constant. That is, the dielectric constant of the nanofibers 11 is preferably anisotropic in the axis, the horizontal direction, and the vertical direction. The nanofibers 11 are not particularly limited as long as they are fibers having an anisotropic dielectric constant.

When the thickness of the nanofibers 11 is represented by an equivalent circle diameter, generally, the average thickness (that is, the average diameter) of the nanofibers 11 is preferably 0.3 nm - 1000 nm, more preferably 1 nm - 100 nm, and even more preferably 2 nm - 50 nm. The thickness of the nanofibers 11 can be determined by using a light scattering device, a laser microscope, a scanning electron microscope (SEM), a transmission electron microscope (TEM), and the like. For example, by measuring the radial lengths of a given number of nanofibers 11 (for example, 10 - 200 nanofibers 11), randomly selected by using an SEM, a TEM, and the like, and calculating their average value, the average diameter of the nanofibers 11 can be determined.

Carbon nanotubes (hereinafter also referred to as "CNTs") can be suitably used as nanofibers 11.

The carbon nanotubes may be either single-walled carbon nanotubes (SWCNTs) or multi-walled carbon nanotubes (MWCNTs).

The average number of walls of carbon nanotubes is preferably 2 walls - 30 walls, more preferably 3 walls - 15 walls. The maximum number of walls of carbon nanotubes is preferably 40 walls or less, more preferably 30 walls or less. The minimum number of walls of carbon nanotubes is preferably 25 walls or less, more preferably 20 walls or less.

The diameter of carbon nanotubes is preferably 0.3 nm - 200 nm, more preferably 1 nm - 100 nm, and even more preferably 2 nm - 50 nm. The cross-section of carbon nanotubes may be substantially circular, elliptical, polygonal, or the like.

The number of walls of carbon nanotubes, the distribution of the numbers of walls, the diameters of carbon nanotubes, and so forth, described above, can be measured based on, for example, an image captured by an SEM or a TEM.

As shown in FIG. 1, the fiber aggregate 10 has a first orientation part 101, a second orientation part 102, and a third orientation part 103 that are each formed in a part in the thickness direction of the fiber aggregate 10.

The first orientation part 101 is an area provided on the upper surface 10b-side, and has a predetermined degree of orientation. The degree of orientation of the nanofibers 11 forming the first orientation part 101 is relatively high.

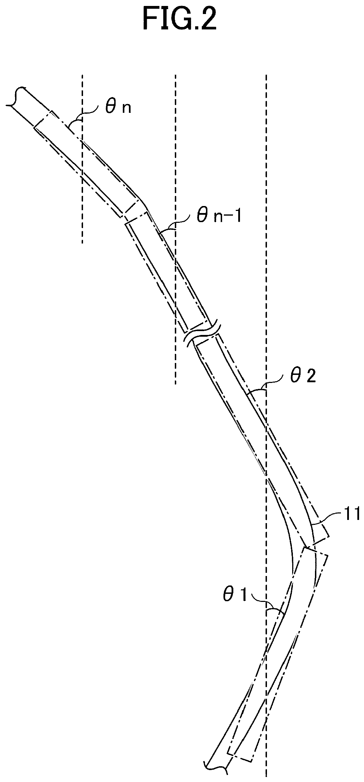

In this embodiment, assuming that the angle of the nanofibers 11 with respect to the thickness direction of the fiber aggregate 10 is θ, the degree of orientation is cosθ of that angle θ. That is, the degree of orientation represents the magnitude of angle of the nanofibers 11 with respect to the thickness direction of the fiber aggregate 10. Referring now to FIG. 2, assuming that the angles of a number of nanofibers 11 that are present in the first orientation part 101 are angles θn (n is an integer equal to or greater than 1), and the average value of these angles θn is an average angle θ_{α}, then the degree of orientation of the first orientation part 101 is the value of the cosine (COS θ_{α}) of the average angle θ_{α} of the nanofibers 11 that are present in the first orientation part 101.

The degree of orientation can be determined by, for example, obtaining a cross-sectional image of the fiber aggregate 10, cut vertically with respect to the main surface (the lower surface 10a or the upper surface 10b) of the fiber aggregate 10 (that is, cut in the thickness direction of the fiber aggregate 10), by using a SEM or a TEM, and analyzing the image.

In image analysis, all nanofibers in the image are extracted as needle-shaped particles, so that the orientation angle of each extracted needle-shaped particle can be determined. If each needle-shaped particle has a changing orientation angle, the needle-shaped particle is segmented into portions in which the particle's orientation angle changes by predetermined degrees, and the length of each segmented portion is determined.

Then, in the image, the length of each segmented portion obtained by image analysis is multiplied by the angle of each segmented portion, and the sum of these values is divided by the sum of the length of each segmented portion obtained by image analysis. By this means, it is possible to calculate a weighted average value of the angles of the nanofibers 11 forming the first orientation part 101. The calculated weighted average value can be used as average angle θ_{α} of the nanofibers 11 forming the first orientation part 101. That is, when an image is obtained, by determining (the sum of (the length of each segmented portion × the angle of each segmented portion) / the sum of the length of each segmented portion), average angle θ_{α} of the nanofibers 11 forming the first orientation part 101 can be determined. Then, the degree of orientation of the first orientation part 101 can be determined by determining COSθ_{α} of average angle θ_{α} determined. For such analysis, the needle-shape separation function of image analysis software such as Winroof (manufactured by Mitani Corporation) can be used.

The first orientation part 101 has a predetermined degree of orientation, and the nanofibers 11 have a predetermined angle relative to the thickness direction of the fiber aggregate 10, and this makes it easy for electromagnetic waves incident substantially perpendicularly to the thickness direction of the first orientation part 101 to enter the first orientation part 101 with ease. Also, even if electromagnetic waves that enter the inside of the first orientation part 101 hit the nanofibers 11, the nanofibers 11, which are highly oriented, have a low apparent dielectric constant that is nearly equal to that of air. Consequently, given that the difference between the air and the nanofibers 11 in dielectric constant at the interface is small, the electromagnetic waves get reflected on the surface of the nanofibers 11 only a little, and can enter the inside of the first orientation part 101 with ease.

The first orientation part 101 is preferably formed on one end side (the upper surface 10b-side) of the fiber aggregate 10 in the thickness direction, and is preferably formed in an area including the upper surface 10b of the fiber aggregate 10 and its neighborhood (the vicinity of the upper surface 10b). Note that the upper surface 10b and its neighborhood means a maximum of 20 um from the upper surface 10b in the thickness direction.

Assume that the first orientation part 101 is formed on the upper surface 10b-side in the thickness direction of the fiber aggregate 10. In this case, the first orientation part 101 has a predetermined degree of orientation as described above, and the nanofibers 11 that form the first orientation part 101 have a predetermined angle relative to the thickness direction of the fiber aggregate 10, and therefore this makes it easy for electromagnetic waves that are incident substantially perpendicularly on the upper surface 10b of the fiber aggregate 10 from the outside, to enter inside from the outermost surface of the fiber aggregate 10.

The thickness of the first orientation part 101 is preferably 3.0 um or more, more preferably 5.0 um - 500 µm, and even more preferably 10.0 um - 300 um. If the thickness of the first orientation part 101 is 3.0 um or more, electromagnetic waves can be allowed to enter the inside of the first orientation part 101 deep enough, so that the electromagnetic waves can be prevented from leaking outside.

The thickness of the first orientation part 101 (in the event there are multiple first orientation parts 101 when seen in the thickness direction, the total of the respective thicknesses) is preferably 0.001% - 80%, more preferably 0.01% - 50%, and even more preferably 0.1% - 20% of the thickness of the entire fiber aggregate 10 (that is, the sum of the thickness of the first orientation part 101, the thickness of the second orientation part 102, and the thickness of the third orientation part 103). Making the thickness of the first orientation part 101 0.001% - 80% of the total thickness of the fiber aggregate 10 makes it easy for electromagnetic waves to enter the inside of the first orientation part 101 and difficult to leak outside.

The second orientation part 102 is formed nearer to the reflective substrate 20 than the first orientation part 101 is, and has a lower degree of orientation than the first orientation part 101. The degree of orientation of the second orientation part 102 can be determined in the same way as the degree of orientation of the first orientation part 101. That is, assuming that the angles of a number of nanofibers 11 that are present in the second orientation part 102 are angles θn (n is an integer equal to or greater than 1), and the average value of these angles θn is an average angle θ_{β}, then the degree of orientation of the second orientation part 102 is the value of the cosine (COSθ_{β}) of the average angle θ_{β} of the nanofibers 11 that are present in the second orientation part 102.

The degree of orientation of the second orientation part 102 is lower than the degree of orientation of the first orientation part 101, and therefore the nanofibers 11 forming the second orientation part 102 have a greater angle relative to the thickness direction of the fiber aggregate 10 than the nanofibers 11 forming the first orientation part 101. Then, the nanofibers 11 that form the second orientation part 102 are significantly bent and curved in the middle and extend following a significantly tortuous path, and therefore a greater portion of the nanofibers 11 forming the second orientation part 102 does not extend vertically in a columnar shape, than the nanofibers 11 forming the first orientation part 101. Consequently, the nanofibers 11 forming the second orientation part 102 can have variation in the direction in which the nanofibers 11 extend, and therefore the second orientation part 102 may include a portion in which a plurality of nanofibers 11 are three-dimensionally entangled and form a mesh structure.

The nanofibers 11 forming the second orientation part 102 are inclined at a larger angle with respect to the thickness direction of the fiber aggregate 10 than the nanofibers 11 forming the first orientation part 101, so that, when electromagnetic waves enter the second orientation part 102, they are more likely to hit the nanofibers 11 that form the second orientation part 102, and the number of times the electromagnetic waves hit the nanofibers 11 can be increased. Also, when electromagnetic waves hit the nanofibers 11, the nanofibers 11, which are not oriented highly, have an increased apparent dielectric constant. Consequently, given the large difference in dielectric constant between the air and the nanofibers 11 at the interface, the electromagnetic waves are more likely to be reflected on the surface of the nanofibers 11. At this time, part of the electromagnetic waves is absorbed in the nanofibers 11 and transmitted through. Every time an electromagnetic wave hits a nanofiber 11 that forms part of the second orientation part 102 and gets reflected, part of the electromagnetic wave is absorbed in the nanofiber 11 and transmitted through. That is, electromagnetic waves hit the nanofibers 11 and get reflected, and, furthermore, part of the electromagnetic waves is absorbed in the nanofibers 11 and transmitted through. By repeating this, electromagnetic waves can be attenuated. Therefore, in the second orientation part 102, electromagnetic waves can be attenuated as they move deeper into the second orientation part 102 toward the reflective substrate 20, so that, in the end, the second orientation part 102 can absorb all the electromagnetic waves emitted from the outside.

The degree of orientation of the second orientation part 102 relative to the main surface of the reflective substrate 20 is preferably less than 0.80, more preferably 0.77 or less, and even more preferably 0.75 or less. If the degree of orientation of the second orientation part 102 is less than 0.80, the angle of the nanofibers 11 forming the second orientation part 102 increases, so that more electromagnetic waves can be caught in multipath reflection. Moreover, since the strength of the fiber aggregate 10 can be increased, the fiber aggregate 10 can be formed into a sheet with more ease.

The difference between the degree of orientation of the first orientation part 101 and the degree of orientation of the second orientation part 102 should be 0.01 or more.

The second orientation part 102 is preferably formed on the other end side (the lower surface 10a-side) in the thickness direction of the fiber aggregate 10. That is, the second orientation part 102 is preferably formed in an area including the lower surface 10a of the fiber aggregate 10 and its neighborhood (the vicinity of the lower surface 10a). Note that the lower surface 10a and its neighborhood means a maximum of 20 um from the lower surface 10a in the thickness. If the second orientation part 102 is formed on the lower surface 10a-side in the thickness direction of the fiber aggregate 10, it becomes easy for electromagnetic waves that enter the inside of the fiber aggregate 10 to be attenuated for certain through the second orientation part 102.

The thickness of the second orientation part 102 is preferably 3.0 um or more, more preferably 5.0 um - 50 µm, and even more preferably 10.0 um - 200 µm.

The thickness of the second orientation part 102 (in the event there are multiple second orientation parts 102 when seen in the thickness direction, the total of the respective thicknesses) is preferably 0.001% - 80%, more preferably 0.01% - 50%, and even more preferably 0.1% - 20% of the thickness of the entire fiber aggregate 10 (that is, the sum of the thickness of the first orientation part 101, the thickness of the second orientation part 102, and the thickness of the third orientation part 103). If the thickness of the second orientation part 102 is within the above preferable range, it is possible to have more electromagnetic waves enter the inside of the second orientation part 102 and get reflected by the nanofibers 11 forming the second orientation part 102. Therefore, it is possible to have electromagnetic waves attenuated with more ease, improve the performance of shielding electromagnetic waves, and, furthermore, maintain the shape of the sheet of the fiber aggregate 10 to be stable.

The third orientation part 103 is formed between the first orientation part 101 and the second orientation part 102. The degree of orientation of the third orientation part 103 is not particularly limited as long as the degree of orientation does not change abruptly between the first orientation part 101 and the second orientation part 102, and may be higher than that of the first orientation part 101, or may be in between the degree of orientation of the first orientation part 101 and the degree of orientation of the second orientation part 102.

For example, when the degree of orientation of the third orientation part 103 is higher than that of the first orientation part 101, the area in which electromagnetic waves travel with ease inside the fiber aggregate 10 without getting reflected or absorbed by the nanofibers 11 becomes thicker, so that it is possible to say that the first orientation part 101 becomes thicker in effect. In this case, even if electromagnetic waves that pass through the first orientation part 101 and enter the third orientation part 103 hit the nanofibers 11 that form the third orientation part 103, the reflection on the surface of the nanofibers 11 is alleviated, and so the electromagnetic waves can move forward in the third orientation part 103. Thus, more electromagnetic waves can enter the inside of the fiber aggregate 10.

In the event the degree of orientation of the third orientation part 103 is in between the degree of orientation of the first orientation part 101 and the degree of orientation of the second orientation part 102, the area in which the electromagnetic waves get easily reflected and absorbed by the nanofibers 11 becomes thicker, and so it is possible to say that the second orientation part 102 becomes thicker in effect. In this case, the electromagnetic waves that pass through the first orientation part 101 and enter the third orientation part 103 can travel inside the third orientation part 103 while getting reflected and attenuated in multipath reflection by the nanofibers 11 forming the third orientation part 103, so that the electromagnetic waves that enter the inside of the fiber aggregate 10 can be efficiently absorbed.

The degree of orientation of the third orientation part 103 can be determined in the same way as the degree of orientation of the first orientation part 101 and the second orientation part 102. That is, assuming that the angles of a number of nanofibers 11 that are present in the third orientation part 103 are angles θn (n is an integer equal to or greater than 1), and the average value of these angles θn is an average angle θ_{γ}, then the degree of orientation of the third orientation part 103 is the value of the cosine (COSθ_{γ}) of the average angle θ_{γ} of the nanofibers 11 that are present in the third orientation part 103.

The thickness of the third orientation part 103 is the thickness of the fiber aggregate 10 minus the thicknesses of the first orientation part 101 and the second orientation part 102, is not particularly limited, and can be designed as appropriate.

The overall thickness of the fiber aggregate 10 can be designed as appropriate, and is preferably, for example, 5 um - 5000 µm, more preferably 10 um - 4000 µm, and even more preferably 100 um - 2000 um. The thickness of the fiber aggregate 10 can be determined by using a known measurement method. For example, the average value of a predetermined number of points (for example, 3 points), sampled randomly in a range 0.2 mm or more inside from the end of the fiber aggregate 10 in the plane direction, may be used.

The nanofibers 11 that form the fiber aggregate 10 enter the fine unevenness formed on the surface of the reflective substrate 20, and contact and follow the surface of the reflective substrate 20, so that Van der Waals forces can act between the nanofibers 11 and the surface of the reflective substrate 20, and the fiber aggregate 10 can become adhesive to the reflective substrate 20. This adhesive force allows the fiber aggregate 10 to adhere to the reflective substrate 20, so that the fiber aggregate 10 can be directly stacked on the reflective substrate 20 without using a pressure-sensitive adhesive or the like.

The fiber aggregate 10 preferably sets the adhesive force between the fiber aggregate 10 and the reflective substrate 20 to 0.2 N/cm² or more, more preferably 0.25 N/cm² or more, and even more preferably 0.3 N/cm². If the adhesive force is 0.2 N/cm² or more, the fiber aggregate 10 can be kept stuck to the reflective substrate 20.

Note that the adhesive force is the force that is required to separate the fiber aggregate 10 and the reflective substrate 20 in the vertical direction. The adhesive force can be determined by pulling the laminate 1A vertically from both the lower surface 10a and the upper surface 10b at a predetermined speed (for example, 1 mm/min) and measuring the force at which the laminate 1A fractures. Note that the fracture of the laminate 1A includes the interfacial fracture between the fiber aggregate 10 and the reflective substrate 20, and the fracture inside the fiber aggregate 10 or the reflective substrate 20. The adhesive force can be measured by using a known tensile tester, pin stubs, load cells, and the like. The adhesive force may be the average value when measured multiple times (for example, twice).

### (Reflective substrate)

The reflective substrate 20 is a substrate on which the fiber aggregate is placed, and has a reflectance of 0.1% or more for high-frequency electromagnetic waves above the millimeter wave band. The reflective substrate 20 preferably has smoothness in order to place the fiber aggregate 10 on its main surface in a stable manner.

For the reflective substrate 20, any material having a reflectance of 0.1% or more can be used as the base material. Materials to form the reflective substrate 20 include, for example: metals such as silicon, aluminum, and copper; metal oxides such as quartz glass, zirconia, and alumina; carbides such as silicon carbide; nitrides such as silicon nitride, aluminum nitride, and gallium nitride; synthetic resins; and the like.

Next, the method of making the laminate according to this embodiment will be described. The laminate 1A can be made by making a fiber aggregate 10 by forming a first orientation part 101 and a second orientation part 102 in nanofibers and then placing the fiber aggregate 10 on a reflective substrate 20.

The method of making the fiber aggregate 10 will be described.

A case in which the nanofibers 11 are carbon nanotubes will be described below. In this case, the fiber aggregate 10 can be produced, for example, by forming a catalyst layer on a base material, supplying a carbon source while activating the catalyst by heat, plasma, or the like, and growing carbon nanotubes. Then, it is preferable to manufacture the fiber aggregate 10 by a chemical vapor deposition method (CVD method). By means of this method, it is possible to make an aggregate of carbon nanotubes as the fiber aggregate 10, in which the base material has a first orientation part 101 and a second orientation part 102, which, as a whole, is oriented substantially perpendicular to its lower surface 10a and upper surface 10b, and in which each carbon nanotube's length extends from the lower surface 10a to the upper surface 10b.

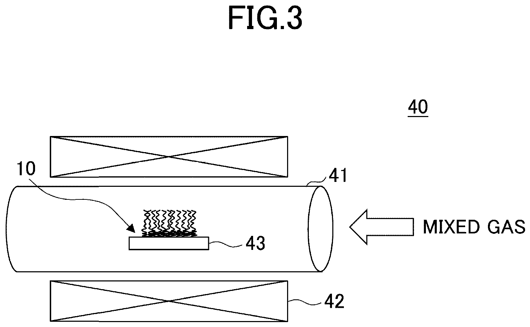

As for the apparatus for making the fiber aggregate 10, any apparatus that can produce carbon nanotubes can be used, and, for example, a thermal CVD apparatus can be used. An example of a thermal CVD apparatus is shown in FIG. 3. As shown in FIG. 3, a thermal CVD apparatus 40 includes a cylindrical reaction vessel 41 and a tubular electric furnace 42 surrounding the reaction vessel 41. As for the reaction container 41, for example, a heat-resistant quartz tube or the like is preferable for use. The tubular electric furnace 42 may be one of a resistance heating type or the like. The fiber aggregate 10 can be made by placing a base material (growth base material) 43 in the thermal CVD apparatus 40 and growing carbon nanotubes thereon.

Materials to form the base material 43 include, for example, materials that are smooth, and that are high temperature/heat resistant and can withstand the making of carbon nanotubes. Examples of such materials include: metal oxides such as quartz glass, zirconia, and alumina; metals such as silicon (silicon wafers, etc.), aluminum, and copper; carbides such as silicon carbide; nitrides such as silicon nitride, aluminum nitride, and gallium nitride; and the like.

In making the carbon nanotubes that form the fiber aggregate 10, a catalyst layer made of any catalyst may be placed on the base material. The catalysts may be, for example, a metal catalyst such as iron, cobalt, nickel, gold, platinum, silver, and copper.

When making the fiber aggregate 10, it is preferable to optionally provide an intermediate layer between the base material and the catalyst layer. Materials to form the intermediate layer include, for example, metals and metal oxides, and metal oxides are more preferable. For the metal oxide, alumina or the like is suitable for use.

The amount of the intermediate layer that can be used to make the fiber aggregate is preferably 50 ng/cm² - 10000 ng/cm², more preferably 100 ng/cm² - 9000 ng/cm², and even more preferably 200 ng/cm² - 8000 ng/cm². By adjusting the amount of the intermediate layer within the above range, a fiber aggregate 10 with a first orientation part 101 and a second orientation part 102 can be formed with ease.

Any appropriate method can be employed as the method of forming the catalyst layer. Methods for forming the catalyst layer include, for example, the method of depositing a metal catalyst by electron beam (EB), sputtering, etc., and the method of coating a base material with a suspension of metal catalyst fine particles.

A catalyst layer formed by the above methods can be used to make the fiber aggregate 10 by atomizing the catalyst layer into a plurality of fine particles by heating or the like. When doing so, if the number/density of atomized particles of the catalyst on the intermediate layer or the base material is too large, each carbon nanotube might interfere with its adjacent carbon nanotubes and tends to grow substantially vertically, and this makes it difficult to reduce the degree of orientation in the second orientation part 102 of the fiber aggregate 10. On the other hand, if the number/density of atomized particles of the catalyst on the intermediate layer or the base material is too low, the strength of the fiber aggregate 10 will be insufficient, which makes it difficult to handle the fiber aggregate 10 in the form of a sheet. Therefore, in view of the above, the number/density of atomized particles of the catalyst on the intermediate layer or the base material is preferably 5/µm² - 10,000/µm², more preferably 50/µm² - 5,000/µm², and even more preferably 100/µm² - 2000/µm².

The density/number of atomized particles of the catalyst on the intermediate layer or the base material can be controlled by controlling the amount of the catalyst layer, the heating temperature and heating time during atomization, and so forth.

The amount of catalyst layer that can be used to make the fiber aggregate is preferably 50 ng/cm² - 3000 ng/cm², more preferably 100 ng/cm² - 2500 ng/cm², and even more preferably 200 ng/cm² - 2000 ng/cm². By adjusting the amount of the catalyst layer within the above range, a fiber aggregate 10 with a first orientation part 101 and a second orientation part 102 can be formed with ease.

The heating temperature for the atomization of the catalyst is preferably 600 degrees Celsius - 1000 degrees Celsius, more preferably 650 degrees Celsius - 950 degrees Celsius, and even more preferably 700 degrees Celsius - 900 degrees Celsius. At the above heating temperature, a fiber aggregate 10, with a properly formed first orientation part 101 and second orientation part 102 can be obtained.

Note that, when heating the catalyst, the catalyst can be made active by using plasma as well as by heat, but activating by heat is more preferable from the viewpoint of ease of operation and the cost of production.

The heating time for the atomization of the catalyst is preferably 0 minute - 180 minutes, more preferably 5 minutes - 150 minutes, and even more preferably 10 minutes - 120 minutes. Through the above heating, a fiber aggregate 10 with a properly formed first orientation part 101 and second orientation part 102 can be obtained. Note that the heating time refers to the heating time at a given set temperature.

As for the size of the fine catalyst particles formed by the above-described heating method of the like, the average particle diameter of the equivalent circle diameter is preferably 1 nm - 100 nm, more preferably 5 nm - 70 nm, and even more preferably 10 nm - 50 nm. If the size of the fine catalyst particles is within the range of the average particle size of the equivalent circle diameter, a fiber aggregate 1 with a properly formed first orientation part 101 and second orientation part 102 can be obtained with ease.

Subsequently, the catalyst atomized by the above method is made active by heat, plasma, or the like, and a carbon source is supplied to grow carbon nanotubes.

Examples of carbon sources that can be used to make carbon nanotube aggregates include: hydrocarbons such as methane, ethylene, acetylene, benzene; alcohol such as methanol and ethanol; and the like. Depending on what type of carbon source is used, the formation of the first orientation part 101 and the second orientation part 102 can be controlled. Among them, ethylene is preferable for use. The use of ethylene as the carbon source facilitates the formation of the first orientation part 101 and the second orientation part 102.

The carbon source is supplied as a mixed gas with one or more of hydrogen, water vapor, and inert gas. By controlling the composition of the mixed gas, the degree of orientation of the fiber aggregate to be generated can be controlled, so that the formation of the first orientation part 101 and the second orientation part 102 can be controlled. For example, by controlling the concentration of hydrogen and water vapor in the mixed gas, and controlling the number/density of catalyst fine particles and the average particle diameter of the equivalent circle diameter as appropriate, the first orientation part 101 and the second orientation part 102 may be formed with an appropriate degree of orientation.

Given the above perspective, the concentration of the carbon source (preferably ethylene) in the mixed gas at 23 degrees Celsius is preferably 1 vol% - 30%, more preferably 3 vol% - 25 vol%, even more preferably 5 vol% - 20 vol%.

The concentration of hydrogen in the mixed gas at 23 degrees Celsius is preferably 10 vol% - 80 vol%, more preferably 20 vol% - 70 vol%, even more preferably 30 vol% - 60 vol%.

Also, the concentration of water vapor in the mixed gas at 23 degrees Celsius is preferably 10 ppm - 5000 ppm, more preferably 50 ppm - 3000 ppm, even more preferably 100 ppm - 2000 ppm.

The rest of the mixed gas is preferably an inert gas such as helium or nitrogen. The concentration of inert gas in the mixed gas at 23 degrees Celsius is preferably 10 vol% - 95 vol%, more preferably 20 vol% - 90 vol%.

The volume ratio between the carbon source (preferably ethylene) and hydrogen (hydrogen/carbon source) in the mixed gas at 23 degrees Celsius is preferably 1 - 40, more preferably 2 - 15. If the volume ratio is within the above range, a fiber aggregate having a first orientation part 101 and a second orientation part 102 with appropriate degrees of orientation can be made.

Any temperature can be employed as appropriate as the temperature for making the fiber aggregate 10. In order to form catalyst particles that can develop sufficiently to form a first orientation part 101 and a second orientation part 102 with appropriate degrees of orientation, the temperature for making the fiber aggregate 10 is preferably 400 degrees Celsius - to 1000 degrees Celsius, more preferably 500 degrees Celsius - 900 degrees Celsius, and even more preferably 600 degrees Celsius - 800 degrees Celsius. By setting the temperature for making the fiber aggregate 10 within a range of 400 degrees Celsius - 1000 degrees Celsius, it becomes possible to control the formation of the first orientation part 101 and the second orientation part 102.

Note that the above temperature can be applied to at least one of the atomization of the catalyst and the growth of carbon nanotubes. Also, the same temperature or different temperatures may be applied to the atomization of the catalyst and the growth of carbon nanotubes.

After the fiber aggregate 10 is formed on the base material as described above, the fiber aggregate 10 is obtained by peeling it from the base material. Since the fiber aggregate 10 has the second orientation part 102, the fiber aggregate 10 can be peeled off from the base material while maintaining its sheet-like shape formed on the base material.

After the fiber aggregate 10 is made, the laminate 1A can be made by placing the fiber aggregate 10 on the reflective substrate 20 with its second orientation part 102-side main surface as the lower surface, as described earlier.

Note that, if the base material can be used as the reflective substrate 20, the base material may be used as the reflective substrate 20 as well. In this case, a laminate 1A, in which the fiber aggregate 10 formed with carbon nanotubes is placed on the reflective substrate 20, is obtained.

Thus, the laminate 1A has a fiber aggregate 10 and a reflective substrate 20, and the fiber aggregate 10 has a first orientation part 101 and a second orientation part 102. The nanofibers 11 that form the first orientation part 101 are inclined to a degree that electromagnetic waves can enter the inside of the first orientation part 101 from the thickness direction of the fiber aggregate 10, so that the first orientation part 101 can allow electromagnetic waves to enter the inside of the first orientation part 101 from the upper surface 10b, toward the second orientation part 102. The second orientation part 102 is formed nearer to the reflective substrate 20 than the first orientation part 101 is, and has a lower degree of orientation than the first orientation part 101. This allows the electromagnetic waves entering the inside of the second orientation part 102 to hit the nanofibers 11 and get reflected toward other nanofibers 11. In addition, since part of the electromagnetic waves can be attenuated through the nanofibers 11 and be transmitted therethrough, the electromagnetic waves reflected by the nanofibers 11 can be attenuated more than before the reflection. The electromagnetic waves get reflected, in multipath reflection, by the nanofibers 11 that form the second orientation part 102, so that the second orientation part 102 can allow the electromagnetic waves to travel toward the reflective substrate 20, while making them attenuated, and, in the end, absorb all of the electromagnetic waves. Therefore, few electromagnetic waves reach the reflective substrate 20, and, even if there are electromagnetic waves that get reflected by the reflective substrate 20, the second orientation part 102 can absorb most of these electromagnetic waves.

Therefore, the laminate 1A forms a first orientation part 101 and a second orientation part 102 in the fiber aggregate 10 and makes these orientation parts have different degrees of orientation, thereby making it easy for electromagnetic waves to enter the inside of the fiber aggregate 10, and reducing the leakage of electromagnetic waves that enter the inside of the fiber aggregate 10 to the outside. Furthermore, by forming the fiber aggregate 10 with nanofibers 11, the fiber aggregate 10, in its first orientation part 101 and second orientation part 102, can allow electromagnetic waves of higher frequency bands such as millimeter waves having frequencies in the millimeter wave band (30 GHz - 300 GHz), terahertz waves having frequencies in the terahertz band (300 GHz - 3 THz), infrared rays, visible light, and so forth, to enter inside from the outside, and keep the electromagnetic waves that enter the inside of the fiber aggregate 10 from leaking outside.

Therefore, the laminate 1A can reduce the reflectance of high-frequency electromagnetic waves of and above the millimeter wave band. Therefore, the laminate 1A, when used in an electromagnetic wave absorber, can absorb well high-frequency electromagnetic waves of and above the millimeter wave band.

The laminate 1A can form the first orientation part 101 on one end side (the upper surface 10b-side) in the thickness direction of the fiber aggregate 10. By placing the first orientation part 101 nearer to the surface of the fiber aggregate 10 on which electromagnetic waves are incident, it is possible to allow the electromagnetic waves incident on the fiber aggregate 10 from the outside, to enter the inside of the fiber aggregate 10 for certain, and, at the same time, make the electromagnetic waves attenuated. Therefore, the laminate 1A can lower the reflectance of electromagnetic waves in a more reliable way, and so it becomes possible to further increase the efficiency of absorption of high-frequency electromagnetic waves of and above the millimeter wave band.

In the laminate 1A, one or both of the first orientation part 101 and the second orientation part 102 can be made 3.0 um thick or thicker. If the first orientation part 101 is 3.0 um thick or thicker, electromagnetic waves that are incident from the outside can travel into the first orientation part 101 deep enough, and the electromagnetic waves can be prevented from leaking outside, so that the reflectance of the fiber aggregate 10 for electromagnetic waves can be further reduced. In addition, if the second orientation part 102 is 3.0 um thick or thicker, electromagnetic waves that enter the second orientation part 102 can get reflected enough, in multipath reflection, so that the reflectance of the fiber aggregate 10 for electromagnetic waves can be further reduced. Therefore, the laminate 1A can further reduce the reflectance of electromagnetic waves incident from the outside by making one or both of the first orientation part 101 and the second orientation part 102 3.0 um thick or thicker.

In the laminate 1A, the thickness of the fiber aggregate 10 can be made 10 um - 5000 um. If the fiber aggregate 10 is 10 µm - 5000 µm thick, the fiber aggregate 10 can ensure sufficient thickness for the first orientation part 101 and the second orientation part 102, so that the first orientation part 101 and the second orientation part 102 can demonstrate their respective functions in a reliable way. Therefore, the laminate 1A can further stabilize and lower the reflectance of electromagnetic waves incident from the outside, constantly.

The laminate 1A can make the adhesive force between the fiber aggregate 10 and the reflective substrate 20 0.2 N/cm² or more. As a result of this, the laminate 1A can maintain the state in which the fiber aggregate 10 is stuck to the reflective substrate 20, so that the peeling of the fiber aggregate 10 from the reflective substrate 20 can be reduced. Therefore, the laminate 1A can maintain, constantly, the state in which the reflectance of electromagnetic waves is low.

The laminate 1A can use carbon nanotubes for the nanofibers 11. Carbon nanotubes have a better absorbability for electromagnetic waves than carbon fibers, metal oxide fibers, and the like. In particular, carbon nanotubes have a good absorbability for electromagnetic waves of higher frequency bands such as millimeter waves, terahertz waves, infrared rays, and visible light. Therefore, by using carbon nanotubes for the nanofibers 11 in the laminate 1A, the fiber aggregate 10 can constantly demonstrate absorbability for electromagnetic waves of high frequency bands of and above the millimeter wave band. In addition, given that carbon nanotubes are easy to produce in desired shapes upon making, if carbon nanotubes are used as the nanofibers 11, it becomes even easier to make a fiber aggregate 10 having a first orientation part 101 and a second orientation part 102 having predetermined positions and lengths. Therefore, the laminate 1A can constantly have a fiber aggregate 10 with a low reflectance for electromagnetic waves.

The laminate 1A can have a second orientation part 102 on the lower surface 10a-side of the fiber aggregate 10, that is, in an area near the lower surface 10a. The second orientation part 102 has a lower degree of orientation than the first orientation part 101, and the angle of the nanofibers 11 with respect to the thickness direction of the fiber aggregate 10 is large, so that the laminate 1A can make it easier to capture electromagnetic waves inside the fiber aggregate 10, and have the electromagnetic waves captured inside the fiber aggregate 10 get reflected in multipath reflection and attenuated in the second orientation part 102. In addition, since, in the second orientation part 102, the angle of the nanofibers 11 with respect to the thickness direction of the fiber aggregate 10 is large, the entanglement of the nanofibers 11 with one another can be strengthened, so that the mechanical strength of the fiber aggregate 10 can be improved. Therefore, the laminate 1A can have high strength.

As described above, the laminate 1A according to the present embodiment has excellent absorbability for electromagnetic waves of the millimeter wave band or higher frequency bands, and therefore is suitable for use in an electromagnetic wave absorber. The electromagnetic wave absorber may be formed with the laminate 1A, or may have the laminate 1A along with other members.

Note that, in this embodiment, the first orientation part 101 may be formed from the upper surface 10b of the fiber aggregate 10 to the center part.

In this embodiment, the second orientation part 102 may be formed in the middle in the thickness direction of the fiber aggregate 10. For example, the second orientation part 102 may be formed from the center portion of the fiber aggregate 10 over to the lower surface 10a, or may be formed in the center portion of the fiber aggregate 10.

In this embodiment, the fiber aggregate 10 may be formed with a first orientation part 101 and a second orientation part 102. In this case, the first orientation part 101 may preferably be formed from the upper surface 10b of the fiber aggregate 10 to the center portion, and the second orientation part 102 may preferably be formed from the center portion to the vicinity of the lower surface 10a of the fiber aggregate 10.

### [Second embodiment]

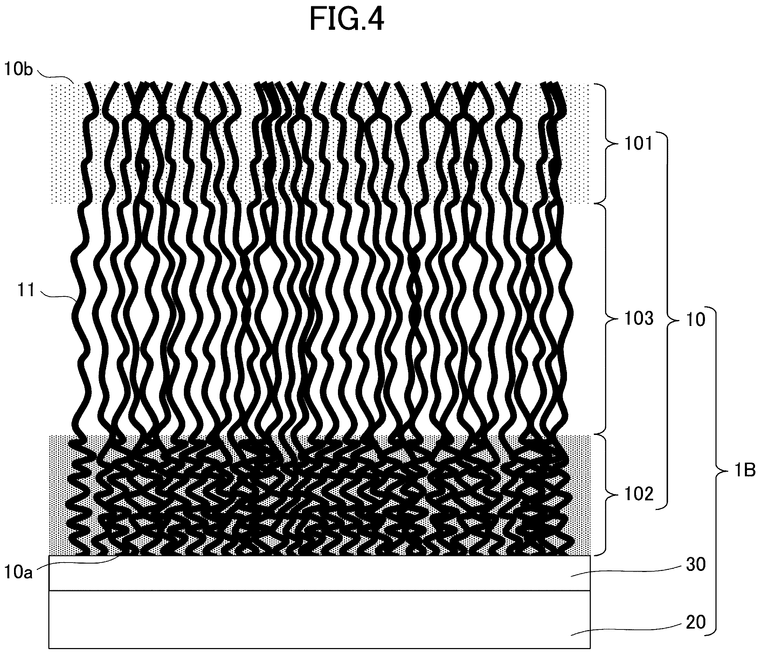

A laminate according to a second embodiment of the present invention will be described with reference to the drawings. FIG. 4 is a diagram that schematically shows the laminate according to this embodiment. As shown in FIG. 4, the laminate 1B according to this embodiment has a joint layer 30 between the fiber aggregate 10 and the reflective substrate 20 in the laminate 1A according to the first embodiment shown in FIG. 1. Since the laminate 1B is the same as the laminate 1A according to the first embodiment except for the joint layer 30, only the configuration of the joint layer 30 will be described here.

The joint layer 30 has the function of joining the fiber aggregate 10 and the reflective substrate 20 together. The joint layer 30 can be formed by using a double-sided adhesive tape, a pressure-sensitive adhesive, an adhesive, and so forth.

A known double-sided adhesive tape can be used as the double-sided adhesive tape.

Any appropriate pressure-sensitive adhesive may be used as long as it can join together the fiber aggregate 10 and the reflective substrate 20. Examples of pressure-sensitive adhesives include acrylic pressure-sensitive adhesives, urethane pressure-sensitive adhesives, silicone pressure-sensitive adhesives, rubber pressure-sensitive adhesives, and the like.

Any appropriate adhesive may be used as long as it can join the fiber aggregate 10 and the reflective substrate 20 together. Examples of adhesives include thermoplastic adhesives, thermosetting adhesives, water-based ceramic adhesives, organic solvent-based ceramic adhesives, and inorganic adhesives. Among these, water-based ceramic adhesives and organic solvent-based ceramic adhesives are preferable because of their excellent durability. Water-based ceramic adhesives are more preferable because they can form adhesive layers with higher durability. Organic solvent-based ceramic adhesives are more preferable because they have excellent affinity with carbon nanotubes and are suitable for use when carbon nanotubes are used as the nanofibers 11.

Examples of thermoplastic adhesives include acrylic resin-based adhesives.

Examples of thermosetting adhesives include alkali metal silicate-based adhesives, phosphate-based adhesives, silica sol-based adhesives, carbon-based adhesives, and silicone-based adhesives.

A water-based ceramic adhesive is an adhesive that can become adhesive by curing a curing component such as an alkali metal silicate, a phosphate (for example, an aluminum phosphate), and a metal alkoxide. A water-based ceramic adhesive can further contain a curing agent (curing accelerator), a filler, and the like. Moreover, a water-based ceramic adhesive can contain any appropriate dispersion medium (for example, water).

The curing agent may be, for example: oxides or hydroxides such as zinc, magnesium, calcium, zinc, and aluminum; silicides such as sodium, potassium, calcium; phosphates such as aluminum and zinc; borates such as calcium, barium, and magnesium; silicates such as magnesium and calcium; group I borates; and the like.

Examples of fillers include: metal oxides such as alumina, silica, zirconia, zinc oxide, magnesium oxide, titanium oxide, and ceria; metal composite oxides such as potassium titanate, strontium titanate, barium titanate, and barium sulfate; nitrides such as aluminum nitride, boron nitride, silicon nitride, and gallium nitride; and the like.

The organic solvent-based ceramic adhesive can contain an inorganic substance, a binder and an organic solvent.

For the inorganic substance, for example, an inorganic compound containing elements such as Al, Si, Ti, and K may be used. The inorganic compound may contain only one of the above elements, or may contain two or more of the above elements. As for the inorganic compound, for example: metal oxides such as alumina, silica, titanium oxide, zirconia, zinc oxide, magnesium oxide, and ceria; metal composite oxides such as potassium titanate, strontium titanate, barium titanate, and barium sulfate; nitrides such as aluminum nitride, boron nitride, silicon nitride, and gallium nitride; carbide such as silicon carbide; a phosphor material obtained by doping an alumina garnet structure with yttrium; and the like can be used.

Examples of binders include: metal alkoxides; silicone resins such as organopolysiloxane; and the like.

As the organic solvent, a volatile organic solvent (for example, an organic solvent with a boiling point of less than 150 degrees Celsius); a non-volatile organic solvent (for example, an organic solvent with a boiling point of 150 degrees Celsius or higher); and so forth, can be used. Examples of non-volatile solvents include ethers such as butyl diglycol ether and diethylene glycol dibutyl ether. After an adhesive is applied to the reflective substrate 20 to form a coating layer, the fiber aggregate 10 is placed over the coating layer, and, when the coating layer is dried to form the joint layer 30, a solvent-based ceramic adhesive containing a non-volatile organic solvent as an organic solvent is used. By this means, unnecessary volatilization of the solvent can be reduced during the process of forming the coating layer on the reflective substrate 20 and placing the fiber aggregate 10 on the coating layer. Therefore, a joint layer 30 having a desired thickness can be formed by reducing the amount of adhesive applied (in effect, the amount of solvent applied).

Examples of inorganic adhesives include ceramic adhesives, silica adhesives, and so forth.

A ceramic adhesive is an adhesive that can become adhesive by curing a curing component such as an alkali metal silicate, a phosphate, and a metal alkoxide. Preferably, a ceramic adhesive that contains an alkali metal silicate or a phosphate (for example, an aluminum phosphate) as a curing component may be used.

A silica-based adhesive is an adhesive that can become adhesive by curing a silica-based curing component such as fine particles of silicic anhydride having silanol groups on the particle surfaces, organopolysiloxane, and so forth. As for the silica-based curing component, for example, silicone-based materials such as fused silica, ultrafine silica particles (for example, particle size: 10 nm - 100 nm), organopolysiloxane, silane compounds, and organosilicon compounds can be used.

Ceramic adhesives and silica-based adhesives can contain, at least, either curing agents (curing accelerator) or fillers. Also, ceramic adhesives can contain any suitable dispersion medium.

In ceramic adhesives, examples of curing agents used in combination with the above alkali metal silicates include: oxides or hydroxides such as zinc, magnesium, and calcium; silicides such as sodium, potassium, and calcium; phosphates such as aluminum and zinc; borates such as calcium, barium, and magnesium; and the like. Examples of curing agents used in combination with the above phosphates include: oxides or hydroxides of magnesium, calcium, zinc, and aluminum; silicates such as magnesium and calcium; group II borates; and the like.

Examples of the fillers include alumina, silica, zirconia, magnesium oxide, and the like.

Any appropriate solvent may be used as the dispersion medium. As for the solvent, an aqueous solvent may be used, or an organic solvent may be used. An aqueous solvent is preferable in that it further enhances the heat resistance of the joint layer 30. In addition, organic solvents are preferable because they have excellent affinity with the fiber aggregate 10 formed of carbon nanotubes.

As for the components in the above ceramic adhesive, it is possible to select optimal materials as appropriate depending on what material forms the base material on which the fiber aggregate 10 is formed. For example, when alumina is used as the intermediate layer to be formed on the surface of the base material, it is preferable to use metal alkoxide as the curing component, alumina as the filler, and alcohol such as methanol as the dispersion medium.

The joint layer 30 preferably sets the adhesive force between the fiber aggregate 10 and the reflective substrate 20 to 0.2 N/cm² or more, more preferably 0.25 N/cm² or more, and even more preferably 0.3 N/cm² or more. If the adhesive force of the joint layer 30 to the fiber aggregate 10 and the reflective substrate 20 is 0.2 N/cm2 or more, the fiber aggregate 10 and the reflective substrate 20 are prevented from peeling, and can be kept joined together.

After the fiber aggregate 10 is made, the fiber aggregate 10 may be stacked on the reflective substrate 20, via the joint layer 30 provided in at least part of the reflective substrate 20, such that the second orientation part 102-side of the main surface of the fiber aggregate 10 is the lower surface, thereby making the laminate 1B.

In the event the joint layer 30 is a double-sided adhesive tape, the double-sided adhesive tape is applied to a position that corresponds to at least part of the surface of the reflective substrate 20 on which the fiber aggregate 10 is placed. The double-sided adhesive tape may be applied to a position of the reflective substrate 20 that corresponds to at least part of the second orientation part 102-side main surface of the fiber aggregate 10, and can be applied to any position of the reflective substrate 20 that corresponds to part or the entirety of the outer circumference of the second orientation part 102-side main surface of the fiber aggregate 10. For example, in the event the fiber aggregate 10 is rectangular in plan view, the double-sided adhesive tape can be applied to positions of the reflective substrate 20 that correspond to, for example, the four corners, part of the opposing sides, and so forth, of the second orientation part 102-side main surface of the fiber aggregate 10. Then, by attaching the second orientation part 102-side main surface of the fiber aggregate 10 to the double-sided adhesive tape, the fiber aggregate 10 can be fixed to the reflective substrate 20 via the double-sided adhesive tape as the joint layer 30.

When the joint layer 30 is formed by using a pressure-sensitive adhesive or an adhesive, a coating liquid of the pressure-sensitive adhesive or the adhesive is applied to a position that corresponds to at least part of the surface of the reflective substrate 20 on which the fiber aggregate 10 is placed, thereby forming a coating layer. The coating layer may be formed at a position corresponding to at least part of the second orientation part 102-side main surface of the fiber aggregate 10, and can be formed at a position of the reflective substrate 20 corresponding to part or the entirety of the outer circumference of the second orientation part 102-side main surface of the fiber aggregate 10. For example, in the event the fiber aggregate 10 is rectangular in plan view, the coating layer can be formed at positions of the reflective substrate 20 corresponding to the four corners, part of the opposing sides, and so forth, of the second orientation part 102-side main surface of the fiber aggregate 10. Then, after the second orientation part 102-side main surface of the fiber aggregate 10 is brought into contact with the coating layer, the coating layer is cured to form the joint layer 30, which serves as a curing substance, so that the fiber aggregate 10 can be fixed to the reflective substrate 20 via the joint layer 30.

Thus, by providing the joint layer 30 between the fiber aggregate 10 and the reflective substrate 20, the laminate 1B can join together the fiber aggregate 10 and the reflective substrate 20 in a stable way. To allow electromagnetic waves to enter the inside of the fiber aggregate 10 and to reduce the leakage of electromagnetic waves that enter the inside of the fiber aggregate 10 to the outside, it is important that the fiber aggregate 10 is fixed such that the angle of the nanofibers 11 forming the first orientation part 101 included in the fiber aggregate 10 does not change, as much as possible, with respect to the traveling direction of the electromagnetic waves. Since the laminate 1B can fix the fiber aggregate 10 to the reflective substrate 20 in a stable way by means of the joint layer 30, it is possible to prevent the incidence angle of electromagnetic waves from changing with respect to the upper surface 10b of the fiber aggregate 10. Therefore, the laminate 1B can allow electromagnetic waves to enter the inside of the fiber aggregate 10 in a stable way, and furthermore reduce, in a more reliable way, the leakage of electromagnetic waves that enter the inside of the fiber aggregate 10 to the outside.

### [Third embodiment]

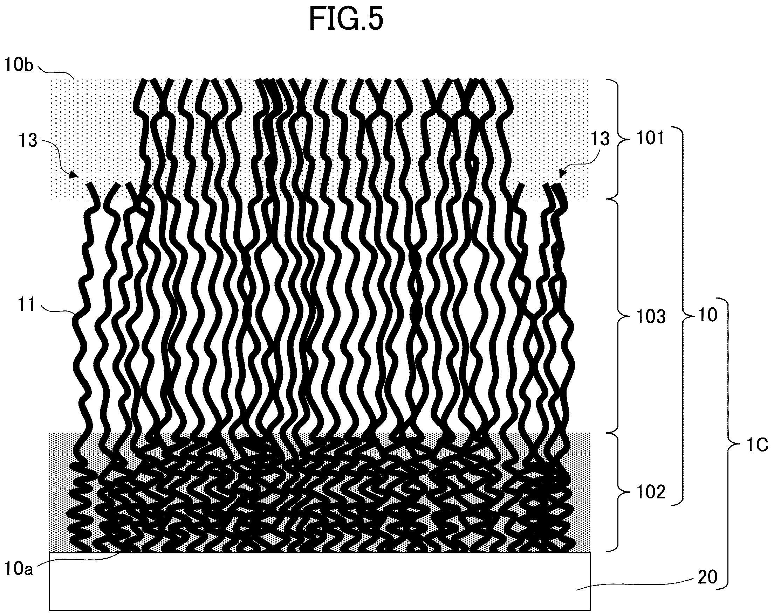

A laminate according to a third embodiment of the present invention will be described with reference to the drawings. FIG. 5 is a diagram that schematically shows the laminate according to this embodiment. As shown in FIG. 5, the laminate 1C according to this embodiment has a compressed part 13, which is lower in thickness than the fiber aggregate 10, in the laminate 1A according to the first embodiment shown in FIG. 1.

The compressed part 13 can be formed by applying a predetermined load to part of the upper surface 10b of the fiber aggregate 10 and compressing the fiber aggregate 10 toward the reflective substrate 20. When doing so, the nanofibers 11 forming the compressed part 13 are pressed against the surface of the reflective substrate 20, so that the nanofibers 11 become adhesive to the reflective substrate 20, and the compressed part 13 can be adhered to the reflective substrate 20. Note that the magnitude of the load is not particularly limited, and can be set as appropriate according to the size of the fiber aggregate 10, the size of the compressed portion 13 formed, and so forth.

The compressed portion 13 has a thickness that is 95% or less, preferably 93% or less, and more preferably 90% or less, of the thickness of the fiber aggregate 10. If the thickness of the compressed part 13 is 95% or less with respect to the thickness of the fiber aggregate 10, when the compressed part 13 is formed by applying a load to part of the fiber aggregate 10, the nanofibers 11 can be press-bonded to the surface of the reflective substrate 20 and become adhesive to the reflective substrate 20.

The compressed part 13 may set the adhesive force between the fiber aggregate 10 and the reflective substrate 20 to 0.2 N/cm² or more, preferably 0.25 N/cm² or more, more preferably 0.3 N/cm² or more. If the adhesive force of the compressed part 13 to the fiber aggregate 10 and the reflective substrate 20 is 0.2 N/cm² or more, the fiber aggregate 10 and the reflective substrate 20 are prevented from peeling and can be kept joined together.

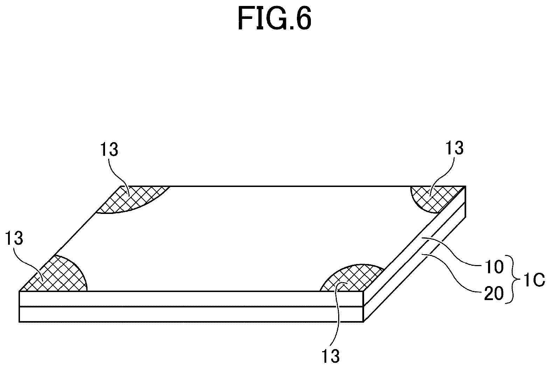

The compressed part 13 is preferably formed in at least part of the fiber aggregate 10 in plan view. It is preferable to determine the position of the compressed part 13 as appropriate according to the shape, size, and so on of the fiber aggregate 10. FIG. 6 is a perspective view of the laminate. As shown in FIG. 6, when the fiber aggregate 10 is rectangular in plan view, the compressed part 13 can be formed at the four corners of the upper surface 10b of the fiber aggregate 10. As a result of this, the bonding of the fiber aggregate 10 with the reflective substrate 20 can be enhanced at the four corners, so that the fiber aggregate 10 can be adhered to the reflective substrate 20 in a more stable way. In addition, the compressed part 13 may be formed in at least part of a pair of opposing sides of the upper surface 10b of the fiber aggregate 10, or may be formed in at least part of three or four sides among the four sides of the upper surface 10b.

The laminate 1C is obtained by placing the fiber aggregate 10 on the reflective substrate 20 and then pressing part of the fiber aggregate 10 from the upper surface 10b-side of the fiber aggregate 10 and forming the compressed part 13.

Thus, the laminate 1C has a compressed part 13 on the fiber aggregate 10, and the adhesive force generated by the compressed part 13 allows the fiber aggregate 10 and the reflective substrate 20 to be joined together in a stable way. As described in the second embodiment, to allow electromagnetic waves to enter the inside of the fiber aggregate 10 and to reduce the leakage of electromagnetic waves that enter the inside of the fiber aggregate 10 to the outside, it is important that the fiber aggregate 10 is fixed such that the angle of the nanofibers 11 forming the first orientation part 101 included in the fiber aggregate 10 does not change, as much as possible, with respect to the traveling direction of the electromagnetic waves. Since the laminate 1C fixes the fiber aggregate 10 to the reflective substrate 20 in a stable way, it is possible to prevent the incidence angle of electromagnetic waves from changing with respect to the upper surface 10b of the fiber aggregate 10, like the laminate 1B according to the second embodiment. Therefore, the laminate 1B can allow electromagnetic waves to enter the inside of the fiber aggregate 10 in a stable way, and furthermore reduce, in a more reliable way, the leakage of electromagnetic waves that enter the inside of the fiber aggregate 10 to the outside.

### [Examples]

Although embodiments of the present invention will be described in more detail by showing examples and comparative examples, the embodiments of the present invention are by no means limited to these examples and comparative examples.

### <Example 1>

### [Preparation of laminate]

On a silicon base material (manufactured by Valqua FFT Inc.: 700 um thick; and the reflectance at 1.0 THz wavelength: 35%), an Al₂O₃ thin film of 3757 ng/cm² was formed (the ultimate degree of vacuum: 8.0 × 10⁻⁴ Pa; the sputtering gas: Ar; and the gas pressure: 0.50 Pa) by using a sputtering device (manufactured by Shibaura Mechatronics Corporation; the product name "CFS-4ES"). On this Al₂O₃ thin film, a Fe thin film of 317 ng/cm² was further formed as a catalyst layer by using the above sputtering device (the sputtering gas: Ar; and the gas pressure: 1.0 Pa).

Next, the base material on which the Al₂O₃ thin film and the catalyst layer were formed was placed in a quartz tube of 30 mm ϕ, and, by letting a mixed gas containing helium and hydrogen (the flow ratio of helium and hydrogen: 105 sccm/80 sccm; and the moisture content: 1000 ppm) flow inside the quartz tube, the air in the quartz tube was replaced with the mixed gas. After that, while the mixed gas kept flowing, the temperature inside the tube was raised to 765 degrees Celsius by using a tubular electric furnace (the time the temperature inside the tube was kept at 765 degrees Celsius: 0 minutes), and the Fe forming the catalyst layer was atomized.

After the temperature in the tube reached 765 degrees Celsius, by letting a mixed gas containing helium, hydrogen, and ethylene (the flow ratio of helium, hydrogen, and ethylene: 90 sccm/80 sccm/15 sccm; and the moisture content: 1000 ppm) flow in the quartz tube for 60 minutes and replacing the gas inside the quartz tube, carbon nanotubes were grown on the silicon base material.

The supply of the raw-material gas was stopped, and the mixed gas containing helium and hydrogen (the flow ratio of helium and hydrogen: 105 sccm/80 sccm; and the moisture content: 1000 ppm) was cooled to room temperature while flowing in the quartz tube.

By the above operation, a 1000 pm-thick, sheet-like fiber aggregate was formed on the catalyst layer, and thus a fiber aggregate was obtained. The fiber aggregate was then separated from the silicon base material, and a double-sided adhesive tape (No. 5000NS; manufactured by Nitto Denko Corporation) was applied to the installation surface of a reflective substrate (silicon substrate) at a position corresponding to the outer periphery of the installation surface of the fiber aggregate. By thus stacking the fiber aggregate on the reflective substrate, a laminate was obtained, in which a fiber aggregate was stacked on a reflective substrate via a double-sided adhesive tape.

[Evaluation of structure of laminate] The thickness of the fiber aggregate that formed the laminate and the degree of orientation of the first and second orientation parts of the fiber aggregate were measured.

### (Measurement of thickness of fiber aggregate)

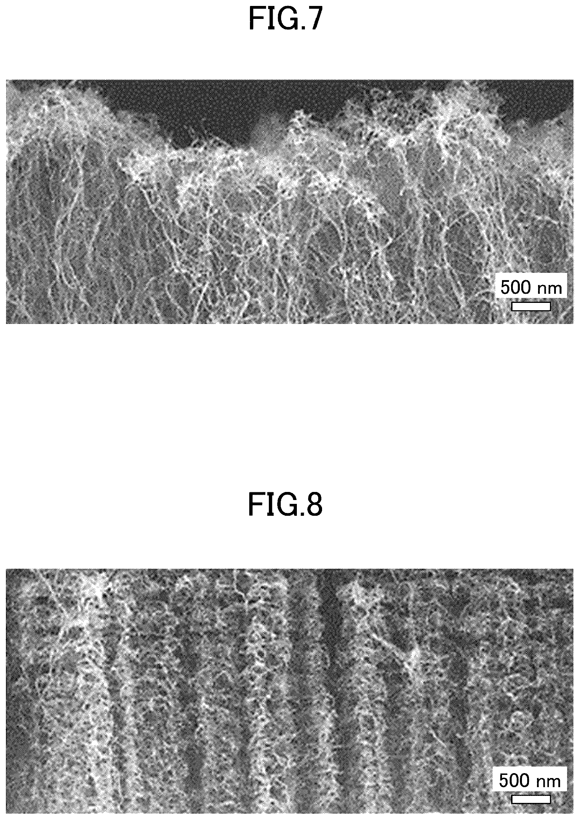

A cross-section of the fiber aggregate was photographed by using an SEM by cutting the fiber aggregate in a direction perpendicular to the plane direction, and the thickness of the fiber aggregate was measured at multiple points to determine the average value. Table 1 shows the measurement results of the thickness of the fiber aggregate. Note that FIG. 7 is an SEM picture that shows a cross-section of the first orientation part in the thickness direction of the fiber aggregate, and FIG. 8 is an SEM picture that shows a cross-section of the second orientation part in the thickness direction of the fiber aggregate. As shown in FIG. 7, the first orientation part of carbon nanotubes was formed near the upper surface of the fiber aggregate, and it was confirmed that the carbon nanotubes were angled to a certain degree. Also, as shown in FIG. 8, a second orientation part with a low degree of orientation of carbon nanotubes was formed near the lower surface of the fiber aggregate, and it was confirmed that multiple carbon nanotubes were entangled with each other and formed a mesh structure.

### (Measurement of degree of orientation of first orientation part and second orientation part of fiber aggregate)

In the fiber aggregate, the degree of orientation of the first orientation part, situated near the main surface of the fiber aggregate, and the degree of orientation of the second orientation part, situated near the lower surface in the thickness direction, were measured. The degree of orientation was measured as follows.

A cross-section of the fiber aggregate was photographed by using an SEM by cutting the fiber aggregate vertically in the plane direction, and a cross-sectional image of a region that was 3 um long and 6 um wide was obtained at a magnification of 20,000×. Considering the carbon nanotube as being needle-shaped particles, the cross-sectional image obtained was subjected to an image analysis by using the needle-shape separation measurement function of WinROOF2018 (manufactured by Mitani Corporation), and the length and the orientation angle of the needle-shaped particles were calculated. This measurement function could separate between intersecting needle-shaped particles and measure them. The calculation based on the image analysis was performed in the following steps. Note that the above orientation angle is the angle with respect to the thickness direction of the fiber aggregate.
1. Setting of calibration
2. Setting of ROI (cutting range: 6 um wide × 3 um long)
3. Removal of background (object size: 0.248 um)
4. Processing through a median filter (filter size: 3 × 3)
5. Lookup table conversion: (histogram average brightness correction, correction reference value: 90)
6. Binarization using a single threshold (threshold: 90; and transparency: 53)
7. Morphology process (closing process; the number of times: 1)
8. Deletion (area of certain particle size: 0.00101 µm²)
9. Separation and measurement of needle-shaped particles (the minimum measurement length: 50 nm; and the maximum measurement width: 5 nm)

To measure the degree of orientation of the first orientation part, an image up to 20 um in the thickness direction, from the main surface that is opposite the side (silicon substrate-side) where the catalyst layer was formed when the laminate was prepared, was obtained, and the length and orientation angle of needle-shaped particles were calculated by analyzing this image.

Then, in the image, the sum of the values obtained by multiplying the length of each segmented portion obtained by image analysis, by the angle of each segmented portion, was divided by the sum of the length of each segmented portion obtained by image analysis. By this means, a weighted average value of the angle of the carbon nanotubes forming the first orientation part was calculated. The weighted average value calculated thus was used as average angle θ_{α} of the carbon nanotubes forming the first orientation part. Then, the degree of orientation of the first orientation part was determined by determining COSθ_{α} of determined average angle θ_{α}.

To measure the degree of orientation of the second orientation part, an image up to 20 um in the thickness direction, from the main surface that is opposite the side (silicon base material-side) where the catalyst layer was formed when the laminate was prepared, was obtained, and the length and orientation angle of needle-shaped particles were calculated by analyzing this image.

Then, in the image, the sum of the values obtained by multiplying the length of each segmented portion obtained by image analysis, by the angle of each segmented portion, was divided by the sum of the length of each segmented portion obtained by image analysis. By this means, a weighted average value of the angle of the carbon nanotubes forming the second orientation part was calculated. The weighted average value calculated thus was used as average angle θ_{β} of the carbon nanotubes forming the second orientation part. Then, the degree of orientation of the second orientation part was determined by determining COSθ_{β} of average angle θ_{β} determined.

Table 1 shows the measurement results of the degrees of orientation of the first orientation part and the second orientation part.

### (Evaluation of reflectance of laminate)

The reflectance of the laminate was measured by using a measurement device (THz-TDS device) that uses the principle of terahertz time domain spectroscopy (THz-TDS method). A pulse wave of a terahertz wave, generated by optical rectification using Mg-doped LiNbO₃ was incident from the first orientation part-side of the laminate, so as to be perpendicular to the upper surface of the fiber aggregate. The terahertz wave reflected by the fiber aggregate was detected by electro-optical sampling using a CdTe crystal. Since the terahertz wave used in this example was a pulse wave, it contained frequency band components of 0.3 THz - 1.0 THz. Therefore, the time domain waveform of the reflected pulse wave of the terahertz wave was obtained and subjected to the Fourier transform, and the reflectance (unit: dB) of the laminate with respect to the electromagnetic wave of 1.0 THz was measured.

### (Measurement of adhesive force of fiber aggregate to reflective base material)

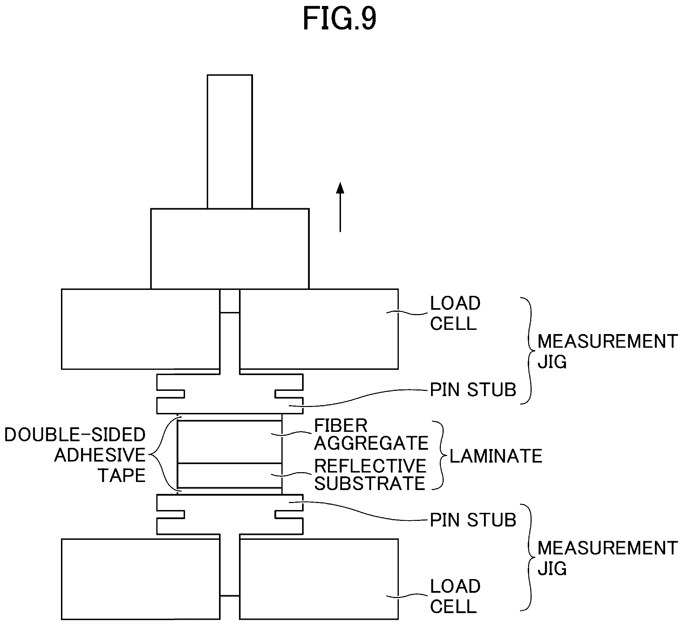

As for the adhesive force of the fiber aggregate to the reflective base material, a tensile test was performed by pulling the laminate in the vertical direction (the direction orthogonal to the main surface of the laminate) at a speed of 1 mm/min, and the force when the laminate fractured was measured. The fracture modes in the tensile test include fracture at the interface between the fiber aggregate and the reflective base material (interfacial fracture) and fracture inside the fiber aggregate or the reflective base material. For the above tensile test, a tensile tester (EZ-S 500N; manufactured by Shimadzu Corporation), pin stubs (made of aluminum; flat part: ϕ12 mm), and load cells (500N screw-type flat grippers; manufactured by Shimadzu Corporation) were used. FIG. 9 shows how the tensile test was performed. As shown in FIG. 9, a pair of measurement jigs, in which pin stubs are fixed to load cells by sandwiching each pin stub's protruding part (pin) between the load cells, were prepared, and a double-sided adhesive tape was affixed on the flat part (base part) of each pin stub. Then, the lower surface of the laminate was fixed to the flat part of the lower pin stub via the double-sided adhesive tape. Subsequently, the flat part of the upper pin stub was placed on the upper surface of the laminate, and a load of 0.5 N was applied to the upper load cell toward the laminate, and the flat part of the upper pin was fixed to the laminate via the double-sided adhesive tape. The upper load cell was pulled by the tensile tester at a tensile speed of 1 mm/min, in the direction opposite the side where its pin stub was fixed, and the force at which the laminate fractured was measured to determine the adhesive force of the fiber aggregate to the reflective base material.

### <Example 2>

Example 2 was carried out in the same way as example 1, except that the heating time for atomizing Fe of the catalyst layer was changed to 30 minutes.

### <Example 3>

Example 3 was carried out in the same way as example 1, except that the amount of the Al₂O₃ thin film formed in the intermediate layer and the amount of the catalyst supported in the catalyst layer were changed.

### <Example 4>

Example 4 was carried out in the same way as example 1, except that the amount of the Al₂O₃ thin film formed in the intermediate layer, the amount of the catalyst supported in the catalyst layer, and the moisture content in the CVD conditions were changed.

### <Example 5>

Example 5 was carried out in the same way as example 1, except that the amount of the Al₂O₃ thin film formed in the intermediate layer, the amount of the catalyst supported in the catalyst layer and the heating time, and the moisture content in the CVD conditions were changed, and the reflective substrate was changed from a silicon substrate to a copper plate. Furthermore, as for the method of preparing the laminate, instead of using a double-sided adhesive tape, a method of stacking the fiber aggregate on the reflective substrate by compressing the four corners of the fiber aggregates in plan view was employed. Other than the above, example 5 was carried out in the same way as example 1.

### <Comparative example 1>

In comparative example 1, the direction of stacking the fiber aggregate on the reflective substrate in example 1 was reversed. That is, the silicon base material, which was used to prepare the fiber aggregate in example 1 was peeled from the fiber aggregate, and the laminate was prepared by sticking the fiber aggregate's main surface, that is, the fiber aggregate's main surface that is opposite the side (the silicon base material-side) where the catalyst layer had been formed upon preparation of the fiber aggregate, to the reflective substrate (silicon). The area 20 um in the thickness direction from the main surface of the fiber aggregate on which the catalyst layer had been formed upon preparation of the fiber aggregate, was made the first orientation part. The area 20 um in the thickness direction from the main surface on the opposite side from the side where the catalyst layer had been formed upon preparation of the fiber aggregate, was made the second orientation part. Other than the above, comparative example 1 was carried out in the same way as example 1.

### <Comparative example 2>

In comparative example 2, the direction of stacking the fiber aggregate on the reflective substrate in example 3 was reversed. That is, the silicon base material, which was used to prepare the fiber aggregate in example 3 was peeled from the fiber aggregate, and the laminate was prepared by sticking the fiber aggregate's main surface, that is, the fiber aggregate's main surface that is opposite the side (the silicon base material-side) where the catalyst layer had been formed upon preparation of the fiber aggregate, to the reflective substrate (silicon). The area 20 um in the thickness direction from the main surface of the fiber aggregate on which the catalyst layer had been formed upon preparation of the fiber aggregate, was made the first orientation part. The area 20 um in the thickness direction from the main surface on the opposite side from the side where the catalyst layer had been formed upon preparation of the fiber aggregate, was made the second orientation part. Other than the above, comparative example 2 was carried out in the same way as example 3.

### <Comparative example 3>

In comparative example 3, the direction of stacking the fiber aggregate on the reflective substrate in example 4 was reversed. That is, the silicon base material, which was used to prepare the fiber aggregate in example 4 was peeled from the fiber aggregate, and the laminate was placed on the reflective substrate without using the double-sided adhesive tape, such that the fiber aggregate's main surface, that is, the fiber aggregate's main surface that is opposite the side (the silicon base material-side) where the catalyst layer had been formed upon preparation of the fiber aggregate, contacted the reflective substrate. Then, the laminate was prepared by stacking the fiber aggregate on the reflective substrate by compressing the four corners of the fiber aggregate in plan view. The area 20 um in the thickness direction from the main surface of the fiber aggregate on which the catalyst layer had been formed upon preparation of the fiber aggregate, was made the first orientation part. The area 20 um in the thickness direction from the main surface on the opposite side from the side where the catalyst layer had been formed upon preparation of the fiber aggregate, was made the second orientation part. Other than the above, comparative example 3 was carried out in the same way as example 4.

### <Comparative example 4>

Comparative example 4 was carried out in the same manner as comparative example 1, except that the fiber aggregate was placed on the reflective substrate without using a double-sided tape.

Table 1 shows the measurement results of the thickness of the fiber aggregate that formed the laminate, the degree of orientation of the first orientation part and the second orientation part of the fiber aggregate, and the adhesive force, according to each example and comparative example.

**[Table 1]**

| | | | | EXAMPLE 1 | EXAMPLE 2 | EXAMPLE 3 | EXAMPLE 4 | EXAMPLE 5 | COMPARATIVE EXAMPLE 1 | COMPARATIVE EXAMPLE 2 | COMPARATIVE EXAMPLE 3 | COMPARATIVE EXAMPLE 4 |
|---|---|---|---|---|---|---|---|---|---|---|---|---|
| LAMINATE | REFLECTIVE SUBSTRATE | | | SILICON BASE MATERIAL | SILICON BASE MATERIAL | SILICON BASE MATERIAL | SILICON BASE MATERIAL | COPPER PLATE | SILICON BASE MATERIAL | SILICON BASE MATERIAL | COPPER PLATE | SILICON BASE MATERIAL |
| | INTERMEDIATE LAYER | AMOUNT OF Al₂O₃ THIN FILM [ng/cm²] | | 3757 | 3757 | 3819 | 4145 | 4145 | 3757 | 3819 | 4145 | 3757 |
| | CATALYST LAYER | AMOUNT OF CATALYST SUPPORTED | Fe [ng/cm²] | 317 | 317 | 1694 | 292 | 292 | 317 | 1694 | 292 | 317 |
| | | CATALYST ATOMIZATION CONDITION | HEATING TEMPERATURE [°C] | 765 | 765 | 765 | 765 | 765 | 765 | 765 | 765 | 765 |
| | | | HEATING TIME [MINUTE] | 0 | 30 | 0 | 0 | 60 | 0 | 0 | 0 | 0 |
| | FIBER AGGREGATE | CVD CONDITIONS | GROWTH TIME [MINUTE] | 60 | 60 | 60 | 60 | 60 | 60 | 60 | 60 | 60 |
| | | | GROWTH TEMPERATURE [°C] | 765 | 765 | 765 | 765 | 765 | 765 | 765 | 765 | 765 |
| | | | MOISTURE CONTENT [ppm] | 1000 | 1000 | 1000 | 470 | 470 | 1000 | 1000 | 470 | 1000 |
| | | COMPOSITION OF MIXED GAS (seem) | He | 105 | 105 | 105 | 105 | 105 | 105 | 105 | 105 | 105 |
| | | | HZ | 80 | 80 | 80 | 80 | 80 | 80 | 80 | 80 | 80 |
| | | | C₂H₄ | 15 | 15 | 15 | 15 | 15 | 15 | 15 | 15 | 15 |
| EVAL-UA-TION | THICKNESS OF FIBER AGGREGATE [*µ*m] | | | 1000 | 1000 | 1000 | 1000 | 1000 | 1000 | 1000 | 1000 | 1000 |
| | DEGREE OF ORIENTATION | FIRST ORIENTATION PART | | 0.80 | 0.87 | 0.93 | 0.86 | 0.73 | 0.72 | 0.79 | 0.78 | 0.72 |
| | | SECOND ORIENTATION PART | | 0.72 | 0.71 | 0.79 | 0.78 | 0.69 | 0.80 | 0.93 | 0.86 | 0.80 |
| | REFLECTANCE OF LAMINATE WITH RESPECT TO 1.0 THz WAVE [dB] | | | -22.0 | -30.2 | -21.6 | -21.7 | -22.1 | -13.2 | -16.5 | -12.0 | -13.5 |
| | ADHESIVE FORCE OF FIBER AGGREGATE TO REFLECTIVE SUBSTRATE [N/cm²] | | | 19.3 | 20.2 | 19.8 | 20.1 | 0.4 | 19.4 | 19.7 | 0.3 | 0 |

According to Table 1, in examples 1 - 5, among the terahertz waves that were incident on the first orientation part-side where the degree of orientation of the fiber aggregate of the laminate was high, the laminate's reflectance for the terahertz wave with a frequency of 1.0 THz was -21.6 dB or lower. On the other hand, in comparative examples 1 - 4, among the terahertz waves that were incident on the first orientation part-side where the degree of orientation of the fiber aggregate of the laminate was low, the laminate's reflectance for the terahertz wave with a frequency of 1.0 THz was -16.5 dB or higher.

Unlike the laminates of comparative examples 1 - 4, the laminates of examples 1 - 5 are configured to accommodate varying degrees of orientation such that the first orientation part, which is located on the side of the fiber aggregate radiated with electromagnetic waves, has a higher degree of orientation than the second orientation part, which is located on the side of the fiber aggregate opposite the side radiated with electromagnetic waves, and the first orientation is radiated with terahertz waves. Unlike the laminates of comparative examples 1 - 4, which are configured to accommodate varying degrees of orientation such that the first orientation part, which is located on the side of the fiber aggregate radiated with electromagnetic waves, has a lower degree of orientation than the second orientation part, which is located on the side of the fiber aggregate opposite the side radiated with electromagnetic waves, it was confirmed that the laminates of examples 1 - 5 could reduce the reflectance of terahertz waves. Therefore, it is possible to say that the laminates according to the embodiments, when used as electromagnetic wave absorbers, can effectively absorb electromagnetic waves having higher frequencies than the terahertz wave band.

Now, although embodiments of the present invention have been described above, these embodiments are presented only by way of example, and the present invention is by no means limited to the above embodiments. The above embodiments can be implemented in various other forms, and various combinations, omissions, replacements, changes, and so forth can be made without departing from the scope of the invention. These embodiments and modifications thereof are included in the scope and gist of the invention, and are included in the scope of the invention described in the claims and equivalents thereof.

This application is based on and claims priority to Japanese Patent Application No. 2020-132858, filed with Japan Patent Office on August 5, 2020, the entire contents of which are incorporated herein by reference.

### Reference Signs List

- 1A, 1B, 1C: laminate
- 10: fiber aggregates
- 101: first orientation part
- 102: second orientation part
- 103: third orientation part
- 10a: main surface (lower surface)
- 10b: main surface (upper surface)
- 11: nanofiber
- 13: compressed part
- 20: reflective substrate

## Claims

1. A laminate comprising:
a fiber aggregate including a plurality of nanofibers aggregated into a sheet; and
a reflective substrate on which the fiber aggregate is placed and which has a reflectance of 0.1% or more,
wherein the fiber aggregate includes:
a first orientation part formed in a part in a thickness direction of the fiber aggregate; and
a second orientation part formed nearer to the reflective substrate than the first orientation part is and having a lower degree of orientation than the first orientation part.

2. The laminate according to claim 1, wherein, in the thickness direction of the fiber aggregate, the first orientation part is formed on an opposite end side from the reflective substrate.

3. The laminate according to claim 1 or 2, wherein one or both of the first orientation part and the second orientation part are 3.0 um thick or thicker.

4. The laminate according to any one of claims 1 to 3, wherein the fiber aggregate is 10 um to 5000 um thick.

5. The laminate according to any one of claims 1 to 4, wherein an adhesive force between the fiber aggregate and the reflective substrate is 0.2 N/cm² or more.

6. The laminate according to any one of claims 1 to 4, further comprising a joint layer between the fiber aggregate and the reflective substrate,
wherein an adhesive force of the joint layer to the fiber aggregate and the reflective substrate is 0.2 N/cm² or more.

7. The laminate according to any one of claims 1 to 4,
wherein the fiber aggregate has a compressed part with a thickness of 95% or less compared to a thickness of another part of the fiber aggregate, and
wherein an adhesive force of the compressed part to the another part of the fiber aggregate and the reflective substrate is 0.2 N/cm² or more.

8. The laminate according to any one of claims 1 to 7, wherein the nanofibers are carbon nanotubes.

9. An electromagnetic wave absorber comprising the laminate according to one of claims 1 to 8.
